Europäisches Patentamt

European Patent Office

Office européen des brevets

(19)

(11) Numéro de publication: **0 360 672**
**A1**

## (12) DEMANDE DE BREVET EUROPEEN

(21) Numéro de dépôt: **89402537.8**

(22) Date de dépôt: **15.09.89**

(51) Int. Cl.⁵: **H 03 H 9/60**

(30) Priorité: **23.09.88 FR 8812469**

(43) Date de publication de la demande:
**28.03.90 Bulletin 90/13**

(84) Etats contractants désignés:
**DE ES FR GB GR IT SE**

(71) Demandeur: **COMPAGNIE D'ELECTRONIQUE ET DE PIEZO-ELECTRICITE - C.E.P.E.**
**44, avenue de la Glacière**
**F-95100 Argenteuil (FR)**

(72) Inventeur: **Schwartz, Laurent**
**THOMSON-CSF SCPI Cédex 67**
**F-92045 Paris la Défense (FR)**

(74) Mandataire: **Guérin, Michel et al**
**THOMSON-CSF SCPI**
**F-92045 PARIS LA DEFENSE CEDEX 67 (FR)**

(54) **Filtre piézoélectrique à sélectivité améliorée utilisant des cellules monolithiques.**

(57) La présente invention concerne un filtre piézoélectrique à N pôles comportant une succession de n (avec n = N/2) cellules monolithiques ($Y_i$) montées en cascade constituées d'une première électrode (1), d'une deuxième électrode (2) et d'une électrode commune (3). Des circuits d'accord ($A_i$) sont insérés dans le circuit. Ils ont une extrémité à la masse. La deuxième électrode (2) d'une cellule ($Y_i$) est connectée à la première électrode (1) de la cellule suivante ($Y_{i+1}$) et à l'autre extrémité d'un des circuits d'accord ($A_{i+1}$). La première électrode (1) de la première cellule ($Y_1$) et la deuxième électrode (2) de la dernière cellule ($Y_n$) sont connectées à un circuit d'accord ($A_1$,$A_{n+1}$). Une capacité ($C_B$) est connectée entre la première électrode et deuxième électrode d'au moins une cellule ($Y_i$).

Une capacité ($C_i$) est insérée entre l'électrode commune (3) de chaque cellule ($Y_i$) et la masse.

Un circuit ($L_{1i}$,$C_{1i}$ parallèle est inséré entre l'électrode commune (3) d'une cellule ($Y_i$) et l'électrode commune (3) de la cellule suivante ($Y_{i+1}$)

Un circuit (($L_{2i}$,$C'_{2i}$),($L'_{2i}$,$C'_{2i}$) parallèle est inséré soit entre l'électrode commune (3) et la deuxième électrode (2) des n-1 dernières cellules ($Y_i$) soit entre l'électrode commune (3) et la première électrode (1) des n-1 premières cellules ($Y_i$).

Ces trois derniers circuits permettent d'améliorer la sélectivité du filtre.

FIG_3

Description

# FILTRE PIEZOELECTRIQUE A SELECTIVITE AMELIOREE UTILISANT DES CELLULES MONOLITHIQUES

La présente invention a pour objet un filtre piézoélectrique, à N pôles, utilisant n (avec n = N/2) cellules monolithiques montées en cascade. L'invention propose d'améliorer la sélectivité de tels filtres.

Une cellule monolithique est constituée de deux résonateurs couplés mécaniquement sur une même lame de matériau piézoélectrique. Sur une face de cette lame on dispose une première et une seconde électrodes en vis-à-vis séparées l'une de l'autre par une distance faible. Sur l'autre face on trouve une troisième électrode commune aux deux résonateurs. Cette troisième électrode peut aussi être constituée de deux électrodes reliées entre elles. Cette troisième électrode est généralement une électrode de masse.

Le nombre de résonateurs utilisés dans un filtre fixe le nombre de pôles du filtre.

Le résumé des performances minimales et/ou maximales exigibles d'un filtre, dans les conditions d'exploitation est défini par des gabarits.

La courbe de synthèse donnant l'affaiblissement (en décibels) en fonction de la fréquence du filtre doit s'inscrire a l'intérieur et/ou l'extérieur des gabarits.

La sélectivité d'un filtre est définie par son facteur de forme K qui est le rapport :

$$K_{X/Y} = \frac{\text{bande atténuée à YdB}}{\text{bande passante à XdB}}$$

La bande atténuée correspond à la largeur de la bande de fréquence mesurée sur la courbe de synthèse a YdB au-dessous de son maximum. La valeur de Y est, par exemple, de -45 décibels.

La bande passante correspond à la largeur de la bande de fréquence mesurée sur la courbe de synthèse a XdB au-dessous de son maximum. La valeur de X est, par exemple, de -3 décibels. Plus la sélectivité d'un filtre est bonne, plus son facteur de forme est faible et plus les flancs de la courbe de synthèse sont raides.

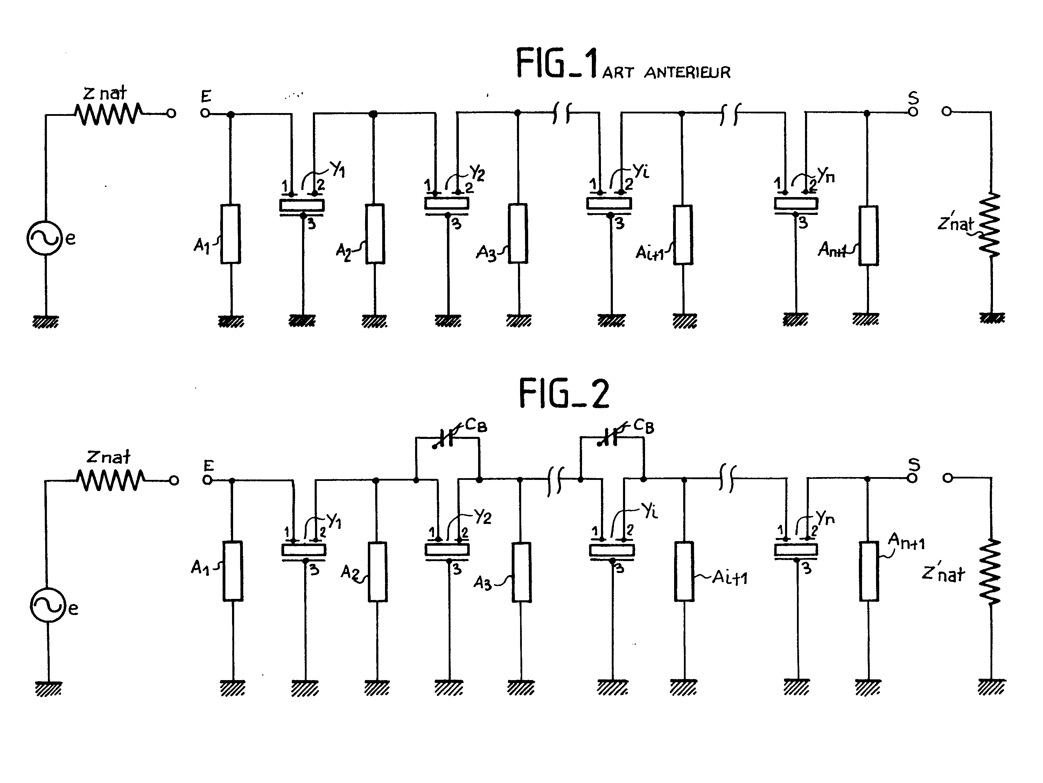

Un filtre piézoélectrique à N pôles utilisant une succession de n cellules monolithiques ($Y_1, Y_2,..., Y_i..., Y_n$) (avec n = N/2) montées en cascade, de type connu est représenté sur la figure 1.

L'entrée du filtre se fait sur une borne active E et la sortie sur une borne active S.

Dans la pratique N est pair et est compris entre 4 et 12. Chaque cellule monolithique ($Y_1, Y_2,...Y_i,...,Y_n$) comporte essentiellement une première électrode 1, une seconde électrode 2 et une troisième électrode 3 commune. La troisième électrode est portée à la masse. Ce filtre est inséré entre une source de force électromotrice e, de résistance interne Znat et une charge Z'nat. Il est bouclé sur son impédance naturelle. Il a une fréquence centrale $F_0$.

Des circuits d'accord $A_i$ au nombre de n + 1 sont insérés dans le circuit du filtre.

La seconde électrode 2 d'une cellule $Y_i$ est reliée d'une part à une première extrémité d'un des circuits d'accord $A_{i+1}$ et d'autre part a la première électrode 1 de la cellule suivante $Y_{i+1}$.

La première électrode 1 de la première cellule $Y_1$ est reliée d'une part à une première extrémité du premier circuit d'accord $A_1$ et d'autre part à la borne d'entrée E. La seconde électrode 2 de la dernière cellule $Y_n$ est reliée d'une part à la première extrémité du dernier circuit d'accord $A_{n+1}$ et d'autre part à la borne de sortie S.

Les secondes extrémités des circuits d'accord ($A_1...A_{n+1}$) sont ä la masse. Les circuits d'accord peuvent être constitués soit d'une capacité, soit d'une inductance, soit d'une capacité et d'une inductance montées en parallèle. Les circuits ($A_1...A_{n+1}$) ne sont pas tous de même type. Toutes les combinaisons sont possibles.

La courbe de synthèse d'un tel filtre, appelé par la suite filtre d'origine, est symétrique et monotone. Elle présente des flancs assez éloignés de la verticale et les points de bande atténuée sont souvent trop proches du gabarit, si l'on veut tenir compte de la dérive thermique et des dispersions de fabrication des composants du filtre. La sélectivité d'un tel filtre n'est pas bonne.

Cette mauvaise performance a plusieurs causes : soit le nombre de résonateurs est insuffisant, soit l'architecture du filtre induit des bouclages à haute fréquence. Ces bouclages se produisent à partir de 70 mHz environ. Ils ont plusieurs origines : concentration plus ou moins bonne du champ des bobinages d'inductance, mauvaise efficacité des blindages, retours de masse selfiques, couplages capacitifs entre pistes du circuit imprimé sur lequel sont montés les composants du filtre.

Pour obtenir une courbe de synthèse plus raide on peut être amené à augmenter le nombre de pôles du filtre, c'est-à-dire à multiplier le nombre de cellules monolithiques. Mais cela entraîne une augmentation des pertes résistives, un encombrement plus important et un coût supplémentaire non négligeable.

Une autre méthode connue pour obtenir une courbe de synthèse plus raide, consiste à déséquilibrer artificiellement le filtre d'origine en le bridant. Un filtre bridé est représenté sur la figure 2. Son schéma est comparable au filtre d'origine représenté sur la figure 1, mais on a ajouté une capacité $C_B$ en parallèle entre la première électrode 1 et la seconde électrode 2 d'au moins une des cellules $Y_i$.

L'introduction de la capacité $C_B$ crée sur la courbe de synthèse des minima ou pointes infinies d'atténuation situées dans la bande atténuée.

Il y a autant de minima que de capacités $C_B$ ajoutées. Les flancs de la courbe de synthèse sont alors plus raides mais cette méthode présente un certain nombre d'inconvénients.

On observe sur la courbe de synthèse une réduction de la bande passante vers les hautes fréquences. Cette réduction est de l'ordre de 5 à 15 % par rapport a la bande passante du filtre d'origine.

On observe également que la courbe de synthèse présente de part et d'autre de la bande atténuée, dans la zone hors bande, des remontées de niveau qui peuvent atteindre de 10 à 20 décibels environ, par rapport à la courbe de synthèse du filtre d'origine.

De plus, le couplage supplémentaire dû aux capacités $C_B$ ajoutées introduit une augmentation des remontées de niveau parasites dans la zone hors bande puisque l'effet du filtrage est diminué dans la zone située de part et d'autre de la bande atténuée.

La présente invention vise à remédier à ces inconvénients. Elle propose un nouveau filtre piézoélectrique à N pôles, utilisant une succession de n cellules monolithiques (avec n = N/2), montées en cascade. Ce filtre à un facteur de forme inférieur à celui du filtre d'origine ayant le même nombre de pôles.

La présente invention propose un filtre piézoélectrique, à N pôles, comportant :
- une borne active d'entrée,
- une borne active de sortie,
- une succession de n (n = N/2) cellules monolithiques montées en cascade constituées chacune essentiellement d'une première électrode, d'une deuxième électrode, et d'une électrode commune,
- une succession de n+1 circuits d'accord ayant tous une première extrémité portée à une masse commune, la deuxième électrode d'une cellule étant reliée d'une part à la première électrode de la cellule suivante, d'autre part, à l'autre extrémité d'un des circuits d'accord, la première électrode de la première cellule étant reliée d'une part à l'autre extrémité du premier circuit d'accord et d'autre part à la borne d'entrée, la deuxième électrode de la dernière cellule étant reliée d'une part à l'autre extrémité du dernier circuit d'accord et d'autre part à la borne de sortie,
- une capacité montée entre la première électrode et la deuxième électrode d'au moins une cellule,
le filtre est caractérisé en ce qu'il comporte
- une succession de n premiers circuits connectés chacun entre l'électrode commune de chaque cellule et la masse ,
- une succession de n-1 deuxièmes circuits connectés chacun entre l'électrode commune d'une cellule et l'électrode commune de la cellule suivante,
- une succession de n-1 troisièmes circuits connectés chacun soit entre l'électrode commune et la deuxième électrode des n-1 dernières cellules, soit entre l'électrode commune et la première électrode des n-1 premières cellules, ces trois successions de circuits contribuant à améliorer la sélectivité du filtre.

Le premier circuit est une capacité. Cette capacité ainsi que la capacité montée entre la première électrode et la deuxième électrode d'au moins une cellule contribuent à la création de pointes infinies d'atténuation sur la courbe de synthèse.

Le deuxième circuit est un circuit LC en parallèle accordé près de la fréquence centrale du filtre. Il annule les différents couplages existant entre les composants du filtre.

Le troisième circuit est un circuit LC en parallèle accordé près de la fréquence centrale du filtre. Il contribue à annuler la tension mesurée aux bornes du premier circuit.

L'adjonction des premier, second et troisième circuits donne des résultats intéressants pour des filtres à N pôles notamment avec N pair, compris entre 4 et 12. Au-delà, l'affaiblissement n'est plus mesurable avec les appareillages actuels.

D'autres caractéristiques et avantages du filtre selon l'invention apparaîtront à la lecture de la description qui va suivre en s'appuyant sur les figures annexées :
   - la figure 1, déja décrite, représente le schéma électrique d'un filtre d'origine à N pôles selon l'art antérieur,
   - la figure 2, déjà décrite, représente le schéma électrique d'un filtre bridé à N pôles selon l'art antérieur,
   - la figure 3 représente le schéma électrique d'une première variante d'un filtre à N pôles selon l'invention,
   - la figure 4 représente le schéma électrique d'une seconde variante d'un filtre à N pôles selon l'invention,
   - la figure 5 représente le schéma électrique d'un filtre selon l'invention à 4 pôles,
   - la figure 6 représente les courbes de synthèse autour de la bande passante d'un filtre d'origine, d'un filtre bridé, d'un filtre selon l'invention, tous les trois à 4 pôles.
   - la figure 7 représente les courbes de synthèse autour de la bande atténuée d'un filtre d'origine, d'un filtre bridé, d'un filtre selon l'invention tous les trois à 4 pôles,
   - la figure 8 représente les courbes de synthèse dans la zone hors bande, d'un filtre d'origine, d'un filtre bridé, d'un filtre selon l'invention tous les trois à 4 pôles.

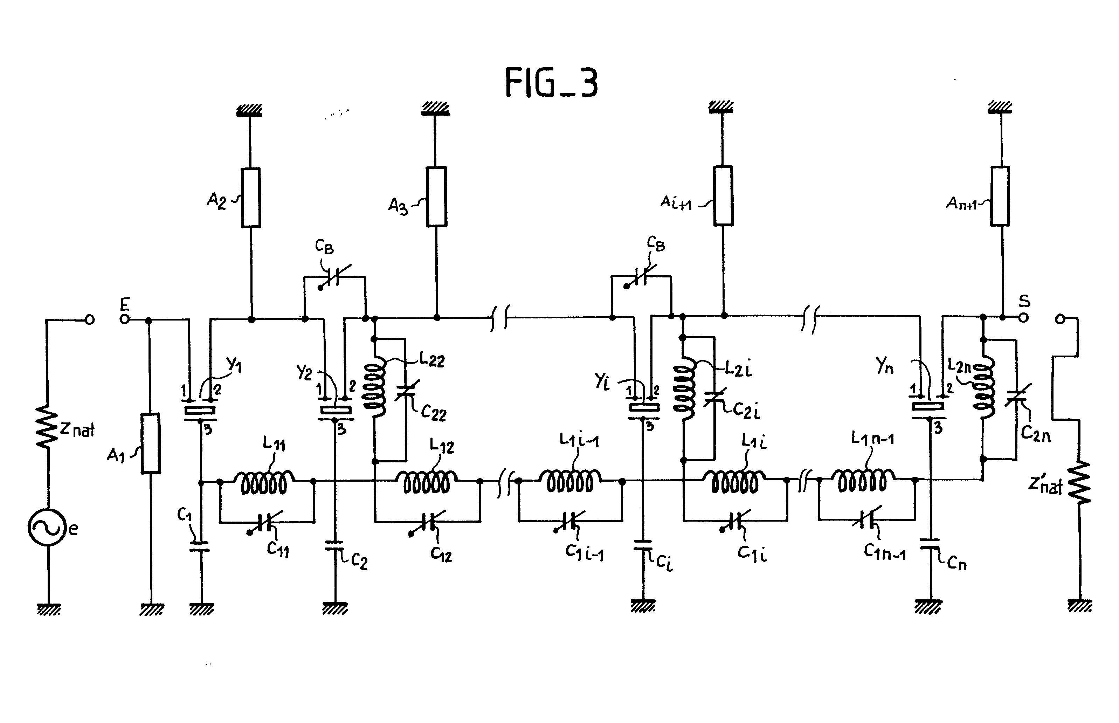

Sur la figure 3 on retrouve tous les composants d'un filtre d'origine et/ou d'un filtre bridé à N pôles décrits précédemment aux figures 1 et 2. Ces composants portent les mêmes références qu'aux figures 1 et 2.

Le filtre comporte en outre, une succession de n premiers circuits $C_i$.

Chaque circuit $C_i$ est inséré entre l'électrode (3) commune d'une cellule $Y_i$ et la masse.

Les premiers circuits $C_i$ sont composés de préférence chacun d'une capacité $(C_1)$, $(C_2))$,...,$(C_i)$,...,$(C_n)$.

Ces n capacités $C_i$ ainsi que les capacités $C_B$ contribuent à la création des pointes infinies d'atténuation sur la courbe de synthèse, en modifiant le couplage interne de chaque cellule $(Y_i)$.

L'introduction de ces n capacités $(C_i)$ provoque une augmentation de la fréquence basse de chaque cellule $(Y_i)$.

Les valeurs des capacités $(C_i)$ seront choisies de manière à obtenir un compromis entre l'amplitude des pointes infinies d'atténuation et le décalage de la fréquence basse.

En pratique on choisira les valeurs de $C_i$ telles que
$$Z_{Ci} = 1/2\pi \ F_o C_i < R_S$$

$F_o$ est la fréquence centrale du filtre

$R_S$ est la résistance série équivalente de la cellule $Y_i$
et telles que :

$F_B/B_p < 5\%$

$F_B$ est la variation de la fréquence basse entre le filtre conforme à l'invention et le filtre d'origine,

$B_p$ est la bande passante du filtre conforme à l'invention à -3dB.

Le décalage de la fréquence basse pourra être annulé en choisissant après les premières mesures des cellules monolithiques $(Y_i)$ dont la fréquence basse est corrigée en conséquence.

Le filtre comporte aussi une succession de seconds circuits $(L_{1i}, C_{1i})$. Chacun de ces seconds circuits $(L_{1i}, C_{1i})$ est inséré entre l'électrode commune 3 d'une première cellule $Y_i$ et l'électrode commune 3 de la cellule suivante $Y_{i+1}$. On dénombre n-1 seconds circuits $(L_{1i}, C_{1i})$ et ils sont composés chacun d'une inductance $L_{1i}$ et d'une capacité $C_{1i}$ montées en parallèle. Ces n-1 seconds circuits $(L_{1i}, C_{1i})$ sont accordés près de la fréquence centrale $F_o$ du filtre. Ils dosent le couplage entre deux cellules consécutives $(Y_i, Y_{i+1})$ Ils annulent les différents couplages existants entre les composants du filtre.

Les mesures montrent qu'il existe plusieurs valeurs pour la capacité $C_{1i}$ et qu'il existe une valeur optimum qui correspond sur la courbe de synthèse aux remontées minimum dans la zone hors bande.

Le filtre comporte enfin une succession de troisièmes circuits $(L_{2i}, C_{2i})$. Chacun de ces troisièmes circuits est inséré entre l'électrode commune 3 et la seconde électrode 2 des n-1 dernières cellules $Y_i$. On dénombre n-1 troisièmes circuits. Ils sont composés chacun d'une inductance $L_{2i}$ et d'une capacité $C_{2i}$ montées en parallèle.

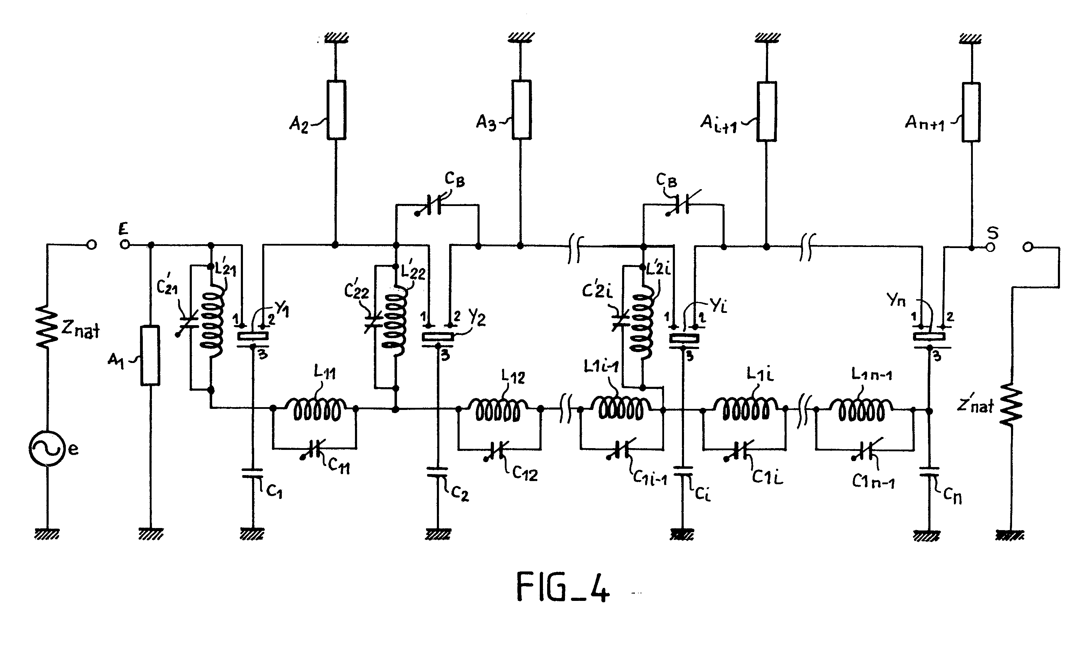

La figure 4 représente un schéma électrique d'une variante d'un filtre selon l'invention. La différence entre le filtre représenté à la figure 3 et celui représenté à la figure 4 provient de la position des troisièmes circuits $(L'_{2i}, C'_{2i})$. Selon une variante, chacun des troisièmes circuits $(L'_{2i}, C'_{2i})$ est inséré entre l'électrode commune 3 et la première électrode 1 des n-1 premières cellules $Y_{2i}$. Chacun des troisièmes circuits $(L'_{2i}, C'_{2i})$ est composé comme précédemment d'une inductance $L'_{2i}$ et d'une capacité $C'_{2i}$ montées en parallèle.

Ces n-1 troisièmes circuits $(L_{2i}, C_{2i})$ ou $(L'_{2i}, C'_{2i})$ sont accordés près de la fréquence centrale $F_o$ du filtre. Ils annulent la tension présente aux bornes des capacités $C_i$.

Ces troisièmes circuits $(L_{2i}, C_{2i})$ ou $(L'_{2i}, C'_{2i})$ annulent la capacitance entre l'électrode commune 3 de la cellule $Y_i$ et soit la deuxième électrode 2, soit la première électrode 1 de cette même cellule $Y_i$.

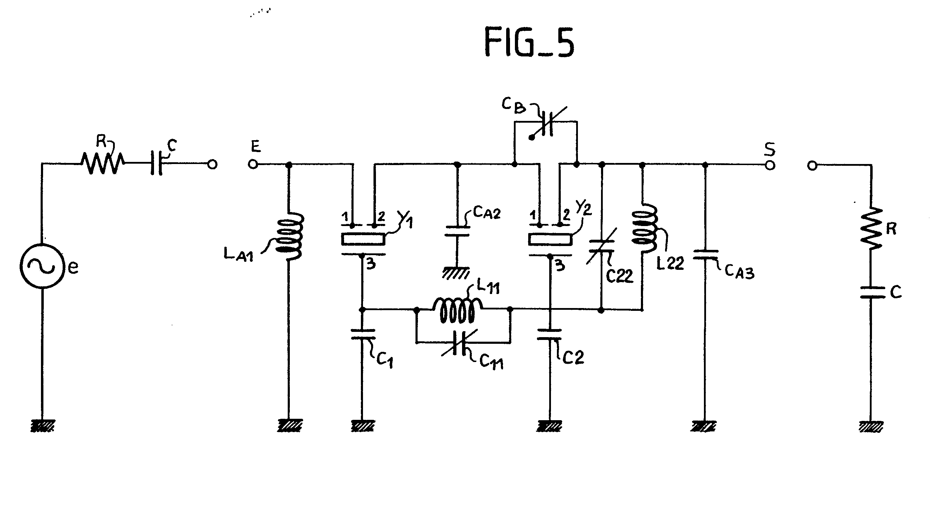

La figure 5 représente le schéma d'un filtre conforme à l'invention à 4 pôles. On y retrouve deux cellules monolithiques $Y_1$, $Y_2$, trois circuits d'accord $A_1$, $A_2$, $A_3$.

Le circuit d'accord $A_1$ est constitué d'une inductance $L_{A1}$. Le circuit d'accord $A_2$ est constitué d'une capacité $C_{A2}$. Le circuit d'accord $A_3$ est constitué d'une capacité $C_{A3}$. D'autres combinaisons auraient pu être utilisées pour les circuits d'accord notamment on aurait pu envisager que l'un d'entre eux soit constitué d'un circuit LC en parallèle. Une capacité

$C_B$ est placée en parallèle entre la première électrode 1 et la seconde électrode 2 de la cellule $Y_2$.

Le circuit comporte aussi une capacité $C_1$ entre l'électrode commune 3 de la cellule $Y_1$ et la masse et une capacité $C_2$ entre l'électrode commune $Y_2$ et la masse.

Un circuit $L_{11}C_{11}$ parallèle est inséré entre l'électrode commune 3 de la cellule $Y_1$ et l'électrode commune 3 de la cellule $Y_2$.

Un circuit $L_{22}C_{22}$ parallèle est inséré entre l'électrode commune 3 et la deuxième électrode 2 de la cellule $Y_2$.

Le filtre représenté est maintenant adapté. L'adaptation représentée est une adaptation passe-haut. L'impédance Znat a été remplacée par une résistance R ou impédance d'adaptation en série avec une capacité C. Il en est de même pour l'impédance Z'nat.

On aurait pu représenter une adaptation passe-bande. On aurait ainsi placé en série avec l'impédance d'adaptation un circuit LC en parallèle.

Les valeurs des principaux composants d'un filtre selon l'invention ayant une fréquence centrale $F_o$ de l'ordre de 85 MHz sont données ci-dessous :

$R = 50$ ohms
$L_{11} = 270$ nH
$C_{11} = 13$ pF
$L_{22} = 390$ nH
$C_{22} = 8,2$ pF
$C_1 = 27$ pF
$C_2 = 27$ pF
$C_B = 0,05$ pF environ cette valeur pouvant être ajustée.

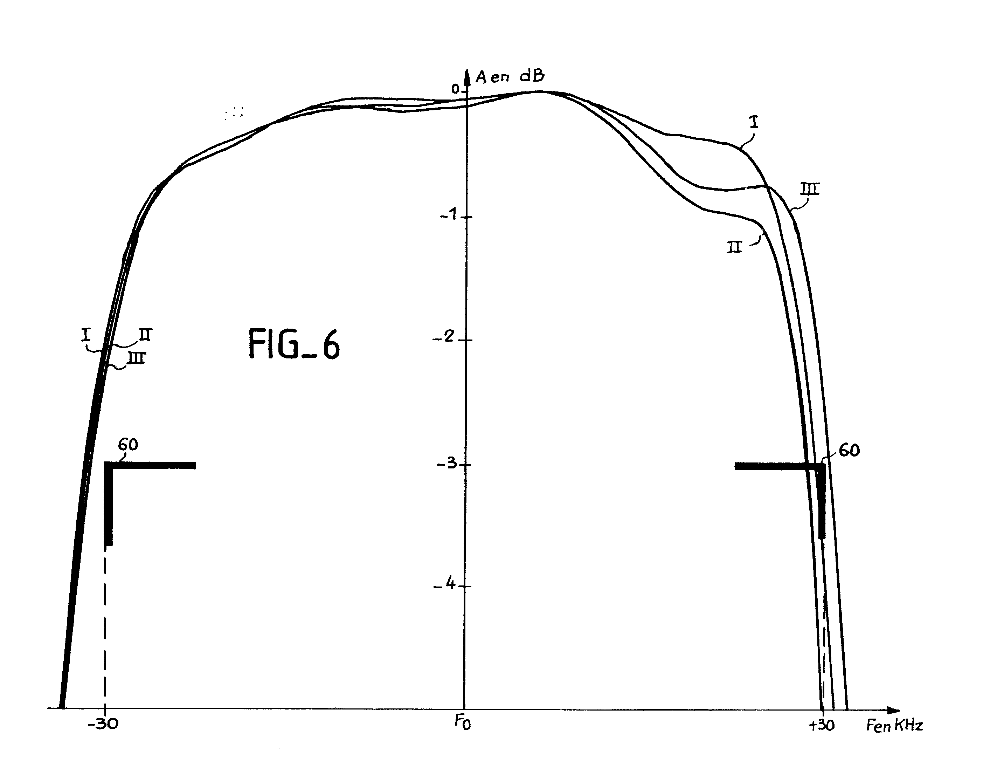

Les courbes III représentées aux figure 6, 7, 8 ont été obtenues avec ces valeurs.

La figure 6 représente la courbe de synthèse d'un filtre d'origine, d'un filtre bridé et d'un filtre selon l'invention autour de la bande passante. Dans notre exemple les trois filtres ont quatre pôles et le filtre selon l'invention correspond au filtre décrit à la figure 5. La courbe de synthèse représente l'affaiblissement A du filtre en décibels en fonction de la fréquence F en kHz. Les courbes représentées sont centrées sur la fréquence centrale $F_o$ du filtre.

La courbe du filtre d'origine porte le repère I.

La courbe du filtre bridé porte le repère II.

La courbe du filtre selon l'invention porte le repère III

Un gabarit 60 est représenté à -3dB de part et d'autre de la fréquence centrale. Il indique que la bande passante minimale du filtre doit être supérieure ou égale à 60 kHz.

La bande passante du filtre d'origine (voir courbe I) est inférieure au gabarit 60.

La bande passante du filtre bridé (voir courbe II) est encore plus faible. Ceci est très sensible du côté des fréquences hautes et cette diminution est liée aux capacités $C_B$ qui déséquilibrent le filtre.

La bande passante du filtre selon l'invention (voir courbe III) est supérieure au gabarit 60. Mais on remarque une très légère augmentation de la fréquence basse par rapport aux courbes I et II. Ceci est lié à l'introduction des capacités $C_1$, $C_2$.

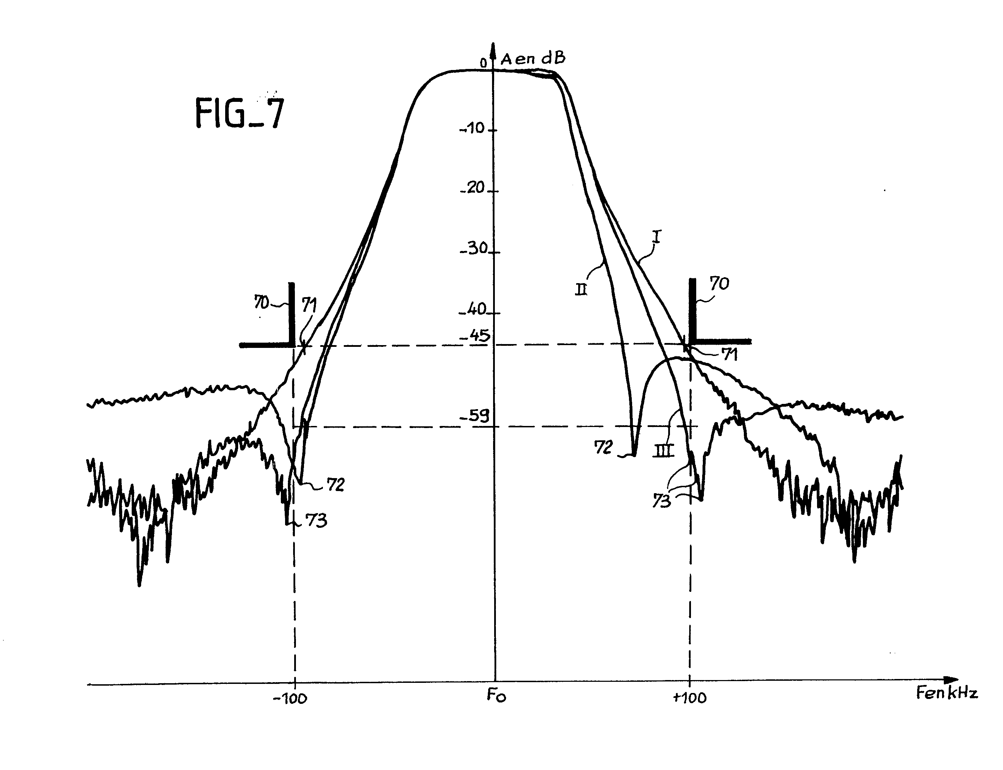

La figure 7 représente la courbe de synthèse des mêmes filtres que précédemment autour de la bande atténué à -45dB. Les courbes portent les mêmes références qu'à la figure 5. Le gabarit placé à -45dB porte la référence 70. La bande atténuée doit être inférieure ou égale a 200 kHz.

Les flancs de la courbe 1 sont assez éloignés de la verticale tandis que ceux des courbes II et III sont plus raides. Les points de bande atténuée 71 de la courbe I sont très proches du gabarit 70. La courbe II du filtre bridé présente au moins une pointe infinie 72 d'atténuation. Cette pointe 72 provient de l'introduction des capacités $C_B$. La courbe II ne présente qu'une seule pointe 72 car on n'a ajouté qu'une seule capacité $C_B$, le filtre considéré n'ayant que deux cellules monolithiques $Y_1, Y_2$.

La courbe III du filtre selon l'invention présente plusieurs pointes infinies 73 d'atténuation. Ces pointes proviennent à la fois de la capacité $C_B$ et des capacités $C_1$ et $C_2$.

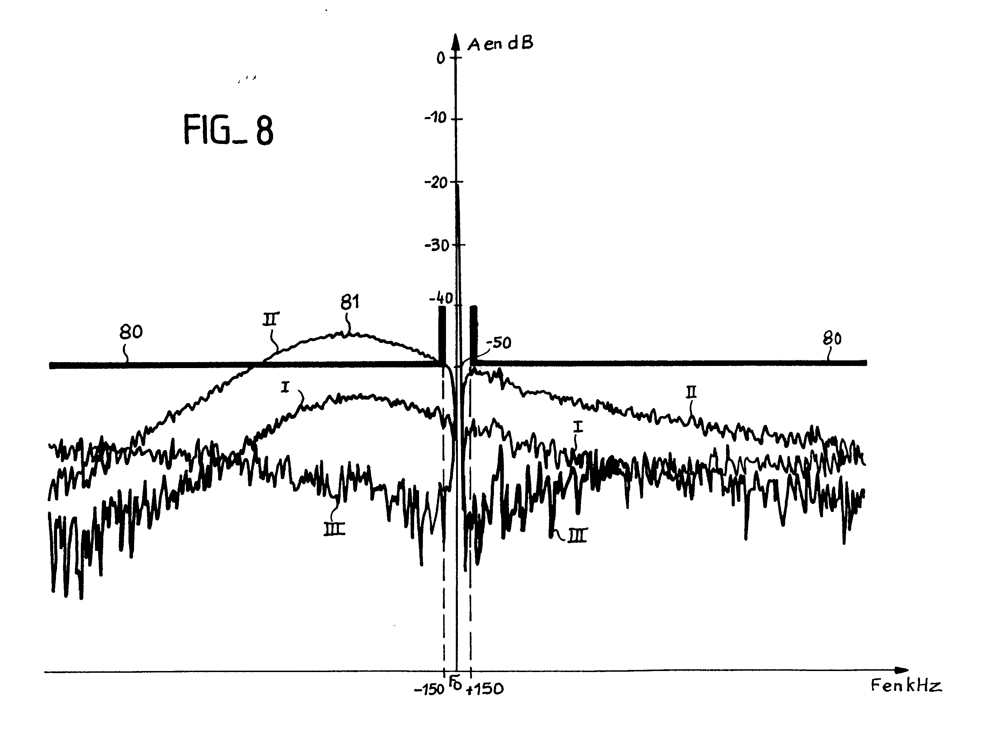

La figure 8 représente comme précédemment les courbes de synthèse dans la zone hors bande. Le gabarit placé a -50dB porte la référence 80. L'affaiblissement hors bande est mesuré de part et d'autre de $\pm$ 150 kHz.

La courbe II du filtre bridé possède une remontée importante 81 vers les basses fréquences. Cette remontée aurait pu se situer aussi bien vers les hautes fréquences. La courbe est déséquilibrée de part et d'autre de la fréquence centrale $F_o$.

La courbe III du filtre selon l'invention est à la fois équilibrée et on ne remarque pas de remontée.

L'introduction du second circuit ($L_{11}C_{11}$ contribue à rééquilibrer la courbe tandis que l'introduction du troisième circuit ($L_{22}, C_{22}$) contribue à supprimer les remontées de la courbe dans la zone hors bande.

La comparaison des différentes largeurs de bandes, et du facteur de forme entre le filtre d'origine et le filtre selon l'invention donne les résultats suivants :

Filtre d'origine
- bande passante à-3dB : 70,4 kHz
- bande atténuée à-45dB : 186 kHz
- affaiblissement en limite du gabarit de bande atténuée : -45dB
- affaiblissement en limite du gabarit de hors bande : -54,7dB
- facteur de forme $K_{3/45}$ : 2,64

Filtre selon l'invention
- bande passante -3dB : 72,4 kHz
- bande atténuée -45dB : 152 kHz
- affaiblissement en limite du gabarit de bande atténuée : -59dB
- affaiblissement en limite du gabarit de hors bande : -70dB
- facteur de forme $K_{3/45}$ : 2,1

Le filtre selon l'invention possède un facteur de forme faible par rapport au filtre d'origine. L'introduction du premier circuit $C_i$, du deuxième circuit ($L_{1i}, C_{1i}$) et du troisième circuit ($L_{2i}, C_{2i}$) ou ($L'_{2i}, C'_{2i}$) permet de diminuer le facteur de forme sans dégrader les caractéristiques de la bande passante.

Ces circuits permettent aussi de supprimer totalement les effets de couplage entraînant des remontées importantes de la courbe de synthèse hors bande.

De plus, pour un filtre d'origine ayant un facteur de forme donné, en introduisant les trois circuits conforme à l'invention il est possible d'accroître les marges de la bande passante tout en conservant la raideur de la courbe du filtre d'origine.

**Revendications**

1. Filtre piézoélectrique à N pôles comportant :
- une borne active d'entrée (E),
- une borne active de sortie (S),
- une succession de n (n=N/2) cellules monolithiques ($Y_1,...,Y_i,...,Y_n$) montées en cascade constituées chacune essentiellement d'une première électrode (1), d'une deuxième électrode (2), et d'une électrode commune (3),
- une succession de n+1 circuits d'accord ($A_1,...,A_i,...A_{n+1}$) ayant tous une première extrémité portée à une masse commune, la deuxième électrode (2) d'une cellule ($Y_i$) étant reliée d'une part a la première électrode (1) de la cellule suivante ($Y_{i+1}$) d'autre part à l'autre extrémité d'un des circuits d'accord ($A_{i+1}$), la première électrode (1) de la première cellule ($Y_1$) étant reliée d'une part à l'autre extrémité du premier circuit d'accord ($A_1$) et d'autre part à la borne d'entrée (E), la deuxième électrode (2) de la dernière cellule ($Y_n$) étant reliée d'une part à l'autre extrémité du dernier circuit d'accord ($A_{n+1}$) et d'autre part à la borne de sortie (S),
- une capacité $C_B$ montée entre la première électrodes (1) et la deuxième électrode (2) d'au moins une cellule ($Y_i$), le filtre est caractérisé en ce qu'il comporte aussi :
- une succession de n premiers circuits ($C_i$) connectés chacun entre l'électrode commune (3) de chaque cellule ($Y_i$) et la masse,
- une succession de n-1 deuxièmes circuits ($L_{1i}, C_{1i}$) connectés chacun entre l'électrode commune (3) d'une cellule ($Y_i$) et l'électrode commune (3) de la cellule ($Y_{i+1}$) suivante,
- une succession de n-1 troisièmes circuits (($L_{2i}, C_{2i}$), ($L'_{2i}, C'_{2i}$)) connectés chacun soit entre l'électrode commune (3) et la deuxième électrode (2) des n-1 dernières cellules ($Y_i$), soit entre l'électrode commune (3) et la première électrode (1) des n-1 premières cellules ($Y_i$), ces trois successions de circuits contribuant à améliorer la sélectivité du filtre.

2. Filtre selon la revendication 1 caractérisé en ce que chaque premier circuit ($C_i$) est constitué d'une capacité.

3. Filtre selon l'une des revendications 1 ou 2 caractérisé en ce que chaque deuxième circuit ($L_{1i}, C_{1i}$) est constitué d'une inductance et d'une capacité en parallèle, accordées près de la fréquence centrale du filtre.

4. Filtre selon l'une des revendications 1 à 3 caractérisé en ce que chaque troisième circuit (($L_{2i}, C_{2i}$), ($L'_{2i}, C'_{2i}$)) est constitué d'une inductance et d'une capacité en parallèle accordées près de la fréquence centrale du filtre.

5. Filtre selon l'une des revendications 1 à 4 caractérisé en ce que le nombre N de pôles est pair et est compris entre 4 et 12.

6. Filtre selon l'une des revendications 1 à 5 caractérisé en ce que les circuits d'accord ($A_l$) sont constitués soit d'une capacité, soit d'une inductance, soit d'une capacité et d'une inductance montées en parallèle.

# FIG_1 ART ANTERIEUR

Z nat

E

$Y_1$ $Y_2$ $Y_i$ $Y_n$

1 2   1 2   1 2   1 2

3   3   3   3

$A_1$   $A_2$   $A_3$   $A_{i+1}$   $A_{n+1}$

e

S

z'nat

# FIG_2

Znat

$C_B$   $C_B$

E

$Y_1$ $Y_2$ $Y_i$ $Y_n$

1 2   1 2   1 2   1 2

3   3   3   3

$A_1$   $A_2$   $A_3$   $A_{i+1}$   $A_{n+1}$

e

S

z'nat

EP 0 360 672 A1

# FIG_3

EP 0 360 672 A1

FIG_4

FIG_5

FIG_6

EP 0 360 672 A1

FIG_7

FIG_8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 028 647 (H. KAI-HEN YEE)<br>* En entier *<br>--- | 1 | H 03 H 9/60 |
| A | FR-A-2 349 999 (NORTHERN TELECOM LTD)<br>* En entier *<br>--- | 1 | |
| A | DE-A-2 005 918 (WESTERN ELECTRIC CO.)<br>* En entier *<br>----- | 1 | |

DOMAINES TECHNIQUES
RECHERCHES (Int. Cl.5)

H 03 H

Le présent rapport a été établi pour toutes les revendications

| Lieu de la recherche | Date d'achèvement de la recherche | Examinateur |
|---|---|---|
| LA HAYE | 29-12-1989 | DECONINCK E.F.V. |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
........................................................................
& : membre de la même famille, document correspondant

EPO FORM 1503 03.82 (P0402)